# EUROPEAN PATENT SPECIFICATION

(11) **EP 3 544 806 B1**
(45) Date of publication and mention of the grant of the patent: **27.01.2021**
(21) Application number: 17874787.9
(22) Date of filing: 08.11.2017
(51) Int. Cl.: H01B 1/22, H01B 1/24, B32B 3/28, B32B 5/22, B32B 27/12, D06M 11/74, D06M 11/83, D06M 23/04, D06M 23/08, D06N 3/00, B32B 27/30, D06N 3/18

(54) **AN ELECTRICALLY CONDUCTIVE MATERIAL FOR APPLYING IT UNDER A NON-CONDUCTIVE WATER INSULATION**
ELEKTRISCH LEITFÄHIGES MATERIAL ZUR VERWENDUNG UNTER EINER NICHTLEITENDEN WASSERISOLIERUNG
MATÉRIAU ÉLECTROCONDUCTEUR DESTINÉ À ÊTRE APPLIQUÉ SOUS UNE ISOLATION CONTRE L'EAU NON CONDUCTRICE

(30) Priority: 25.11.2016 WO PCT/IB2016/057121
(43) Date of publication of application: 02.10.2019
(73) Proprietor: Draudins, Kristaps, 1024 Priedkalne, Garkalnes novads (LV); Senhofs, Karlis, 5052 Ikskile, Ikskiles novads (LV); Liede, Armands, 1073 Riga (LV); Stankevics, Eriks, 2111 Ramava, Kekavas novads (LV)
(72) Inventor: ELERSIC FILIPIC, Kristina, 8290 Sevnica (SI); DRAUDINS, Kristaps, 8290 Sevnica (LV); SENHOFS, Karlis, 8290 Sevnica (LV); LIEDE, Armands, 8290 Sevnica (LV); STANKEVICS, Eriks, 8290 Sevnica (LV)
(74) Representative: Kromanis, Artis
(86) International application number: PCT/IB2017/056982
(87) International publication number: WO 2018/096419

(56) References cited:
- GB-A- 2 485 524
- US-A- 4 442 160
- US-A1- 2001 028 946
- US-A1- 2010 028 672
- US-A1- 2016 312 074
- US-B2- 7 625 633

## Description

### Technical Field

The invention relates to electrically conductive multi-layer materials for leak detection applications. The conductive multilayer materials are especially suitable for water tightness inspections on roofs and other leak proof structures. The invention further relates to the method of manufacture of said electrically conductive multi-layer materials as well as the use thereof.

### Background Art

Because the purpose of a roof or other leak proof structures is to protect people and their possessions from climatic elements, the insulating properties of the roof or other leak proof structures are a consideration. It is necessary to provide a means to control its water tightness. Several number of methods and devices have been developed, unfortunately none of them is significantly accurate, effective or resistant up to date. For example, a late detection and location of the roof seal damage can cause considerable damage to the overall roof structure and even to the building itself Therefore, it is necessary to develop such a sealing, which implements precise and effective leak detection applications and in the mean time is resistant to environment and mechanical damages.

European patent publication No. EP2488361 discloses a method for producing a multilayer sealing structure comprising an electrically conductive inner layer made of asphalt sheets, and asphalt sheets for such a sealing structure.

German patent publication No. DE19638733 discloses plastic seal damage detection method.

United States patent publication No. US5362182 discloses a waste disposal landfill having subsurface impermeable sheets, which can be monitored with respect to their permeability.

United states patent publication No. US5850144 discloses a leak testable, fluid impervious membrane formed as a laminate of a conductive mesh scrim between upper and lower insulated polymeric resin layers.

United States patent publication No. US8604799 discloses a structural seal with electrically conductive layer which is arranged inside or outside structural seal and extends over substantially the entire surface of the structural seal.

German patent application publication No. DE10036362 discloses a system for location of leaks from sealed building structures, e.g. flat roofs, has an electrically conductive layer beneath the sealant layer and an outer electrode within which the voltage distribution is measured.

European patent application publication No. EP2309046 discloses a multilayer fabric laminate comprising at least one polymer nonwoven layer and at least one fabric layer of non-polymer fibres, wherein said layers and have been laminated using at least one B-stage binder. United States patent publication No. US2016312074 discloses an electrically conductive, single-sided tape comprising a conductive adhesive layer and a conductive polymeric layer positioned adjacent the conductive adhesive layer.

The drawback of the above-mentioned two or multilayer materials comprising electrically conductive layers are their complicated installation in structures to be sealed as well as their unsatisfactory conductivity. Said materials are subject to delamination, which decrease its measurement accuracy and effectiveness. Moreover complicated installation leads to increased costs. Additionally, state of art conductive layers do not provide effective conductivity properties overall and on separate points in the sealed structure. Therefore, the aim of the invention is to create a conductive layer with increased conductivity properties and easier installation in structures to be sealed as well as with increased mechanical properties.

### Summary of the Invention

The aim of the invention is reached by design of electrically conductive material for applying it under a non-conductive water insulation layer, for example PVC (polyvinyl chloride) material sheet. The multi-layer material consist of a nonwoven PET (Polyethylene terephthalate) or PP (Polypropylene) polymer layer and a conductive particle coating having conductive particles and acrylic binder. The conductive particles are electrically conductive carbon and/or metal particles. The conductive particle coating can be in the form of a paste or a foam. The acrylic binder encloses or is doped with the electrically conductive carbon and/or metal particles. In another embodiment the nonwoven polymer layer may be soaked or doped with conductive particles compound which comprises electrically conductive carbon and/or metal particles as well as an acrylic binder.

The electrically conductive carbon and/or metal particles are in the range of 0.1 to 20 micrometres. In the following range the particles, especially carbon particles, has the most preferable conductive properties within the material. In another embodiment the electrically conductive carbon and/or metal particles are in the range of 0.2 to 5 micrometres. The particles are laid over all or complete surface of the polymer layer in such amount that the particles are connected to each other. Whole surface area shows uniform conductive properties, accordingly. The electrically conductive carbon and/or metal particles within acrylic binder uniformly cover entire surface of the polymer layer in such an amount that a resistance of conductive particle coating is 1000Ω/sq or less.

The acrylic binder, in which electrically conductive particles are arranged, avoid the use of pressure or heat treatment during manufacture of the electrically conductive material. Therefore, reduces a complexity of manufacturing the electrically conductive material.

The aforementioned combination of the acrylic binder and doped therein the electrically conductive carbon and/or metal particles provides ability to reach resistance of the material at about 1000 Q/m² and less.

The nonwoven PET or PP polymer layer preferably is coated with paste or foam conductive particle coating by the means of direct or foam coating.

The fibres of the nonwoven PET or PP polymer layer are in the range of 0.9 dtex to 16 dtex, preferably 1.7 dtex to 6 dtex. Said fibres can be in the form of yarns and thread.

The metal particles in conductive particle coating can be metal particles selected from the group of metals containing aluminium, copper, aluminium-copper alloy, silver, gold, tin, chromium, iron, molybdenum, niobium, nickel, nickel-chromium alloy, palladium, platinum, silicon, tantalum, titanium and/or stainless steel. The conductive particle coating can be a combination of variety of metal with a combination of carbon particles in graphene as single layered particles or graphite in multi-layered form. In some embodiments the conductive particle coating can be a combination of carbon and metal particles in any combination.

An amount of conductive particle coating in weight percentage (weight%) on polymer nonwoven layer is in range from 1% to 50%, preferably from 10% to 40%, more preferably from 12% to 25%.

The electrically conductive carbon particles are selected from the group of electrically conductive carbons comprising a carbon black, a graphite and/or carbon nanotubes.

The invention also includes a method for manufacture of said electrically conductive material, wherein the method comprises the following steps:
a) providing of a nonwoven PET or PP polymer layer;
b) providing of conductive particle coating consisting of electrically conductive carbon or metal particles and a acrylic binder.
c) coating of the nonwoven PET or PP polymer layer with the conductive particle coating.

The method further includes a step of laying said material onto the PVC (polyvinyl chloride) material sheet. The multi-layer material is laid onto the PVC material sheet by means of lamination.

The coating of the nonwoven PET or PP polymer layer is performed by the technological process which is selected from the following group of the technological processes: direct coating; foam coating; rolling; transferring; spraying; rotary screening; curtain or slot die coating or dipping, preferably using direct or foam coating.

The electrically conductive multi-layer material can be used in the leak detection applications for roof, wall or even tunnel structures or any other structure where precise and effective leak detection is necessary.

### Brief description of the drawings

The following disclosure will be better understood by a person skilled in the art when read in conjunction with the figures.

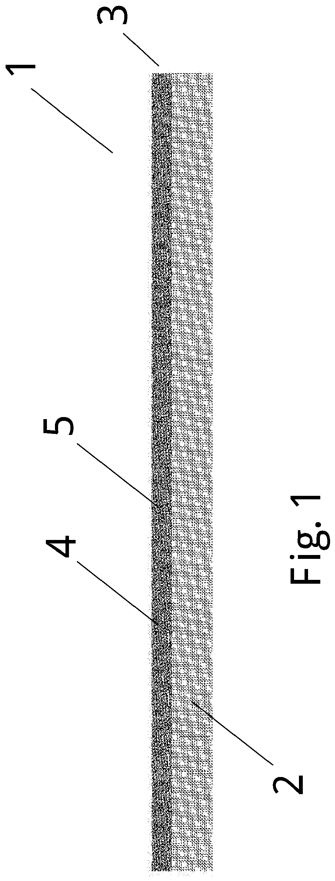

Fig. 1 illustrates a cross-section of an electrically conductive material **1.**
Fig. 2 illustrates a fragment of electrically conductive material **1** coated or laid on a PVC hydro-isolation material **10.**
Fig. 3 illustrates a perspective view of insulated roof structure, where it has a cut-out to illustrate all elements of the exemplary roof structure.

Preferred embodiment of the invention is an electrically conductive material **1** for applying it under a non-conductive water insulation layer **20.** The electrically conductive material **1** comprises a nonwoven PET (Polyethylene terephthalate) polymer layer **2** and a conductive particle coating **3** consisting of electrically conductive carbon particles **4** and acrylic binder **5.**

In another embodiment, the nonwoven polymer layer **2** is soaked or doped with conductive particles compound **3,** which comprises electrically conductive carbon and metal particles **4** and acrylic binder **5.**

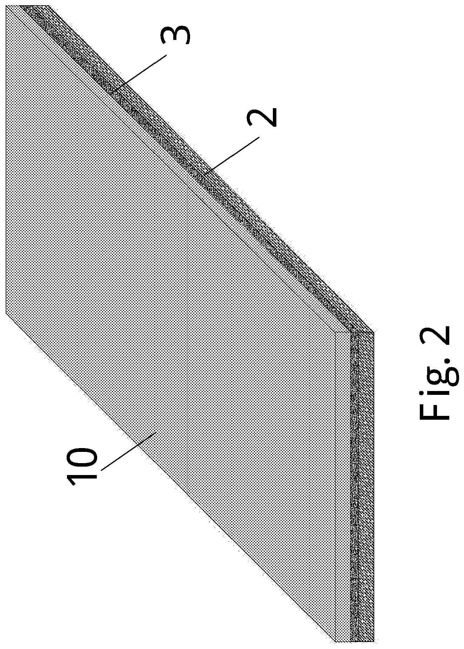

Another embodiment further comprises the electrically conductive material **1** attached to a PVC layer **10** (see Fig. 2). Following combination provides ready to use electrically conductive multi-layer material that is ready to be laid on the roof structure or any other structure to be sealed and controlled for leaks.

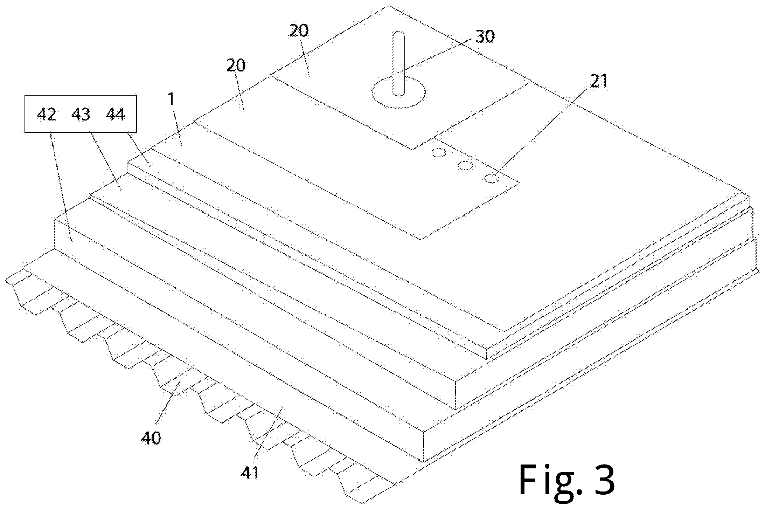

On the roof structure, the electrically conductive material **1** is laid above insulation layers **42, 43** and **44,** especially above an insulation surface layer **44** (Fig. 3). The roof structure comprises a bearing structure **40,** covered by a vapour barrier **41,** which is subsequently covered by insulation layers **42, 43,** and **44.** The insulation layers consist of an insulation base layer **42,** an insulation slope forming layer **43** and an insulation surface layer **44.** The roof structure is sealed by a water insulation layer **20,** which is laid above said electrically conductive material 1. Said insulation layers **20** are connected to each other via connection points **21.** Additionally, the roof structure is provided with contact devices **30.** These contact devices **30** are configured to provide an electric contact between the electrically conductive multi-layer material **1** and sealing inspection device (not shown in figure) to be used for leak detection applications.

## Claims

1. Electrically conductive material (1) for applying it under a non-conductive water insulation layer, comprising a nonwoven PET (Polyethylene terephthalate) or PP (Polypropylene) polymer layer (2) and a conductive particle coating (3) consisting of electrically conductive carbon and/or metal particles (4) in the range of 0.1 to 20 micrometres, preferably 0.2 to 5 micrometres, and an acrylic binder (5), wherein fibres of the nonwoven PET or PP polymer layer are in the range of 0.9 dtex to 16.0 dtex, preferably 1.7 dtex to 6.0 dtex, and wherein
the electrically conductive carbon and/or metal particles (4) within the acrylic binder (5) cover entire surface of the polymer layer (2) in such an amount that a resistance of the conductive particle coating (3) is 1000Ω/sq or less.

2. Electrically conductive material (1) according to claim 1, wherein the acrylic binder (5) encloses the electrically conductive carbon and/or metal particles (4) and electrically conductive carbon and/or metal particles (4) uniformly cover all surface of the polymer layer (2).

3. Electrically conductive material (1) according to claim 1 or 2, wherein the metal particles (4) are metal particles selected from the group of metals containing aluminium, copper, aluminium-copper alloy, silver, gold, tin, chromium, iron, molybdenum, niobium, nickel, nickel-chromium alloy, palladium, platinum, silicon, tantalum, titanium and stainless steel.

4. Electrically conductive material (1) according to claim 1 or 2, wherein the electrically conductive carbon particles (4) are selected from the group of electrically conductive carbons comprising a carbon black, a graphite and carbon nanotubes.

5. Electrically conductive material (1) according to any of preceding claims, wherein a nonwoven PET or PP polymer layer (2) is coated with the conductive particle coating (3) in such a way that said coating (3) can be on one or both sides of the polymer layer (2) or penetrated within the polymer layer (2).

6. Electrically conductive material (1) according to any of preceding claims, wherein said material (1) is attached to a hydro-isolation PVC (polyvinyl chloride) material sheet (10).

7. Electrically conductive material (1) according to any of preceding claims, wherein an amount of conductive particle coating (3) in weight % on polymer nonwoven layer is in range from 1% to 50%, preferably from 10% to 40%, more preferably from 15% to 30%.

8. Method of manufacture an electrically conductive material (1) according to any one of claims 1 to 7, wherein the method comprises the following steps:
a) providing of a nonwoven PET or PP polymer layer (2);
b) providing of a conductive particle coating (3) consisting of electrically conductive carbon or metal particles (4) in the range of 0.2 to 20 micrometres, preferably 0.2 to 5 micrometres, and an acrylic binder (5); and
c) coating of the nonwoven PET or PP polymer layer (2) with the conductive particle coating (3).

9. Method according to claim 8, wherein the coating of the nonwoven PET (Polyethylene terephthalate) or PP (Polypropylene) polymer layer (2) is performed by the technological process which is selected from the following group of the technological processes: direct coating; foam coating; rolling; transferring; spraying; rotary screening; curtain or slot die coating or dipping, preferably using direct or foam coating.

## Patentansprüche

1. Elektrisch leitfähiges Material (1) zum Anwenden desselben unter einer nichtleitenden Wasserisolationsschicht, welche eine nicht gewebte PET (Polyethylenterephthalat)- oder PP (Polypropylen)-Polymerschicht (2) und eine leitfähige Partikelbeschichtung (3), bestehend aus elektrisch leitfähigen Kohlenstoff- und/oder Metallpartikeln (4) in dem Bereich von 0,1 bis 20 Mikrometer, bevorzugt 0,2 bis 5 Mikrometer, und ein Acrylbindemittel (5) umfasst, wobei
Fasern der nicht gewebten PET- oder PP-Polymerschicht in dem Bereich von 0,9 dtex bis 16,0 dtex, bevorzugt 1,7 dtex bis 6,0 dtex sind, und wobei
die elektrisch leitfähigen Kohlenstoff- und/oder Metallpartikel (4) innerhalb des Acrylbindemittels (5) die gesamte Oberfläche der Polymerschicht (2) in einem solchen Ausmaß bedecken, dass ein Widerstand der leitfähigen Partikelbeschichtung (3) 1000 Ω/sq oder weniger ist.

2. Elektrisch leitfähiges Material (1) nach Anspruch 1, wobei das Acrylbindemittel (5) die elektrisch leitfähigen Kohlenstoff- und/oder Metallpartikel (4) umschließt, und elektrisch leitfähige Kohlenstoff- und/oder Metallpartikel (4) einheitlich die ganze Oberfläche der Polymerschicht (2) bedecken.

3. Elektrisch leitfähiges Material (1) nach Anspruch 1 oder 2, wobei die Metallpartikel (4) Metallpartikel sind, ausgewählt aus der Gruppe von Metallen, bestehend aus Aluminium, Kupfer, Aluminium-Kupfer-Legierung, Silber, Gold, Zinn, Chrom, Eisen, Molybdän, Niobium, Nickel, Nickel-Chrom-Legierung, Palladium, Platin, Silizium, Tantal, Titan und Edelstahl.

4. Elektrisch leitfähiges Material (1) nach Anspruch 1 oder 2, wobei die elektrisch leitfähigen Kohlenstoffpartikel (4) ausgewählt sind aus der Gruppe von elektrisch leitfähigen Kohlenstoffen, umfassend ein Rußschwarz, ein Graphit und Kohlenstoffnanoröhren.

5. Elektrisch leitfähiges Material (1) nach einem der vorstehenden Ansprüche, wobei eine nicht gewebte PET- oder PP-Polymerschicht (2) mit der leitfähigen Partikelbeschichtung (3) auf eine solche Weise beschichtet ist, dass die Beschichtung (3) auf einer oder beiden Seiten der Polymerschicht (2) oder innerhalb der Polymerschicht (2) durchdrungen sein kann.

6. Elektrisch leitfähiges Material (1) nach einem der vorstehenden Ansprüche, wobei das Material (1) an einer wasserisolierenden PVC (Polyvinylchlorid)-Materialtafel (10) angebracht ist.

7. Elektrisch leitfähiges Material (1) nach einem der vorstehenden Ansprüche, wobei ein Ausmaß von leitfähiger Partikelbeschichtung (3) in Gew.-% auf nicht gewebter Polymerschicht in dem Bereich von 1 % bis 50 %, bevorzugt von 10 % bis 40 %, bevorzugter von 15 % bis 30 % liegt.

8. Verfahren zum Herstellen eines elektrisch leitfähigen Materials (1) nach einem der Ansprüche 1 bis 7, wobei das Verfahren die folgenden Schritte umfasst:
a) Bereitstellen einer nicht gewebten PET- oder PP-Polymerschicht (2);
b) Bereitstellen einer leitfähigen Partikelbeschichtung (3), welche aus elektrisch leitfähigen Kohlenstoff- oder Metallpartikeln (4) in dem Bereich von 0,2 bis 20 Mikrometer, bevorzugt 0,2 bis 5 Mikrometer, und einem Acrylbindemittel (5) besteht; und
c) Beschichten der nicht gewebten PET- oder PP-Polymerschicht (2) mit der leitfähigen Partikelbeschichtung (3).

9. Verfahren nach Anspruch 8, wobei das Beschichten der nicht gewebten PET (Polyethylenterephthalat)- oder PP (Polypropylen)-Polymerschicht (2) durch den technologischen Prozess durchgeführt wird, welcher ausgewählt wird aus der folgenden Gruppe von technologischen Prozessen: Direktbeschichtung; Schaumbeschichtung; Walzen; Übertragen; Sprühen; Rotationssieben; Lackgießverfahren oder Schlitzdüsenbeschichtung oder Tauchen, bevorzugt unter Verwendung von Direkt- oder Schaumbeschichtung.

## Revendications

1. Matériau électroconducteur (1) pour l'appliquer sous une couche d'isolation contre l'eau non conductrice, comprenant une couche de polymère PET (polyéthylène téréphtalate) ou PP (polypropylène) non tissée (2) et un revêtement de particules conductrices (3) se composant de particules de carbone et/ou de métal électroconductrices (4) dans la plage allant de 0,1 à 20 micromètres, de préférence de 0,2 à 5 micromètres, et un liant acrylique (5), dans lequel
des fibres de la couche de polymère PET ou PP non tissée sont dans la plage allant de 0,9 dtex à 16,0 dtex, de préférence de 1,7 dtex à 6,0 dtex et dans lequel
les particules de carbone et/ou de métal électroconductrices (4) à l'intérieur du lient acrylique (5) recouvrent toute la surface de la couche de polymère (2) en une quantité telle qu'une résistance du revêtement de particules conductrices (3) est 1 000 Ω/carré ou moins.

2. Matériau électroconducteur (1) selon la revendication 1, dans lequel le liant acrylique (5) entoure les particules de carbone et/ou de métal électroconductrices (4) et les particules de carbone et/ou de métal électroconductrices (4) recouvrent uniformément toute la surface de la couche de polymère (2).

3. Matériau électroconducteur (1) selon la revendication 1 ou 2, dans lequel les particules de métal (4) sont des particules de métal sélectionnées dans le groupe constitué par des métaux contenant de l'aluminium, du cuivre, un alliage aluminium-cuivre, de l'argent, de l'or, de l'étain, du chrome, du fer, du molybdène, du niobium, du nickel, un alliage nickel-chrome, du palladium, du platine, du silicium, du tantale, du titane et de l'acier inoxydable.

4. Matériau électroconducteur (1) selon la revendication 1 ou 2, dans lequel les particules de carbone électroconductrices (4) sont sélectionnées dans le groupe constitué par des carbones électroconducteurs comprenant un noir de carbone, un graphite et des nanotubes de carbone.

5. Matériau électroconducteur (1) selon l'une quelconque des revendications précédentes, dans lequel une couche de polymère PET ou PP non tissée (2) est recouverte du revêtement de particules conductrices (3) de telle manière que ledit revêtement (3) puisse être sur un ou deux côtés de la couche de polymère (2) ou pénétrée à l'intérieur de la couche de polymère (2).

6. Matériau électroconducteur (1) selon l'une quelconque des revendications précédentes, dans lequel ledit matériau (1) est fixé à une feuille de matériau PVC (chlorure de polyvinyle) d'hydro-isolation (10).

7. Matériau électroconducteur (1) selon l'une quelconque des revendications précédentes, dans lequel une quantité de revêtement de particules conductrices (3) en % en poids sur une couche non tissée de polymère se trouve dans une plage allant de 1 % à 50 %, de préférence de 10 % à 40 %, plus préférentiellement de 15 % à 30 %.

8. Procédé de fabrication d'un matériau électroconducteur (1) selon l'une quelconque des revendications 1 à 7, dans lequel le procédé comprend les étapes suivantes :
a) la fourniture d'une couche de polymère PET ou PP non tissée (2) ;
b) la fourniture d'un revêtement de particules conductrices (3) se composant de particules de carbone ou de métal électroconductrices (4) dans la plage allant de 0,2 à 20 micromètres, de préférence de 0,2 à 5 micromètres, et d'un liant acrylique (5) ; et
c) le revêtement de la couche de polymère PET ou PP non tissée (2) par le revêtement de particules conductrices (3).

9. Procédé selon la revendication 8, dans lequel le revêtement de la couche de polymère PET (polyéthylène téréphtalate) ou PP (polypropylène) non tissée (2) est réalisé par le processus technologique qui est sélectionné dans le groupe suivant des processus technologiques : une enduction directe ; une enduction de mousse ; un laminage ; un transfert ; une pulvérisation ; un criblage rotatif ; une enduction ou un trempage un en filière à rideau ou à fente, de préférence à l'aide d'une une enduction directe ou de mousse.
